# EUROPEAN PATENT APPLICATION

(11) **EP 4 793 305 A1**
(43) Date of publication of application: **19.08.2026**
(21) Application number: 24876967.1
(22) Date of filing: 03.09.2024
(51) Int. Cl.: C08G 59/72, C08G 65/18, H05K 1/03

(54) **THERMALLY LATENT CATIONIC POLYMERIZATION INITIATOR, CURABLE RESIN COMPOSITION, AND METAL BONDED BODY**

(30) Priority: 10.10.2023 JP 2023175040; 07.03.2024 JP 2024034825
(71) Applicant: Nippon Shokubai Co., Ltd., Osaka-shi, Osaka 541-0043 (JP)
(72) Inventor: MATSUMOTO, Ai, Suita-shi, Osaka 564-0034 (JP)
(74) Representative: Müller-Boré & Partner Patentanwälte PartG mbB
(86) International application number: PCT/JP2024/031612
(87) International publication number: WO 2025/079368

(57) **Abstract**

An object of the present invention is to provide a cationic polymerization initiator which is thermally latent and can control the initiation of polymerization of a compound having a cationically curable functional group by adjusting the temperature, a curable resin composition containing the cationic polymerization initiator, a bonded body of a cured product and a metal in which discoloration of the cured product and the metal under humid heat conditions is suppressed, use of a composition containing the cationic polymerization initiator and an amine compound as a thermal-latent cationic polymerization initiator, a method for curing a curable resin composition containing the cationic polymerization initiator and a compound having a cationically curable functional group, a method for producing a cured product using the cationic polymerization initiator, and a cured product produced by the production method. The thermal-latent cationic polymerization initiator of the present invention includes a specific Lewis acid-type cationic polymerization initiator and an amine compound, wherein the Lewis acid-type cationic polymerization initiator and a moiety of the amine compound form a complex, a remaining moiety of the amine compound is present in a state free from the Lewis acid-type cationic polymerization initiator, and a mole ratio of an amino group contained in the free amine compound to 1 mole of a boron atom contained in the Lewis acid-type cationic polymerization initiator is from 0.15 to 1.70.

## Description

### Technical Field

The present invention relates to a cationic polymerization initiator which is thermally latent and can control the initiation of polymerization of a compound having a cationically curable functional group by adjusting the temperature, a curable resin composition containing the cationic polymerization initiator, a bonded body of a cured product and a metal in which discoloration of the cured product and the metal under humid heat conditions is suppressed, use of a composition containing the cationic polymerization initiator and an amine compound as a thermal-latent cationic polymerization initiator, a method for curing a curable resin composition containing the cationic polymerization initiator and a compound having a cationically curable functional group, a method for producing a cured product using the cationic polymerization initiator, and a cured product produced by the production method.

### Background Art

Epoxy resins are thermosetting and widely used in electronic products such as printed circuit boards, memory, and CPUs due to their high electrical insulation, water resistance, chemical resistance, and the like. **In** addition, due to their high corrosion resistance, epoxy resins are also used as a component of anti-corrosion paints for automobiles, ships, and the like. Further, epoxy resins are used to paint the inner surface of beverage cans. Also, epoxy resins are used as industrial adhesives, and in the construction field, as structural adhesives for concrete and steel plates. Recently, epoxy resins have also been used as adhesives for lightweight, high-strength, high-performance materials such as carbon fiber and glass fiber.

Epoxy monomers are polymerized by a cationic polymerization reaction. The cationic polymerization reaction has advantages over the radical polymerization reaction, as curing inhibition by oxygen does not occur, and shrinkage during curing is small. However, if polymerization is initiated immediately after mixing the epoxy monomer and the cationic polymerization initiator, curing may occur before use.

Therefore, the research group of the present inventors has developed a thermal-latent polymerization initiator composition that contains tris(pentafluorophenyl)borane, which is a cationic polymerization initiator, and a specific amine compound. The thermal-latent polymerization initiator composition does not initiate polymerization at room temperature but initiates polymerization at a lower temperature, and has excellent catalytic ability (Patent Document 1). In addition, a curable resin composition has been developed that contains a cationically curable compound having a cyclic ether group, a cationically curable compound having a double bond, and a specific boron compound, and that is excellent in storage stability and the like and gives a cured product having high transparency and uniformity with good productivity (Patent Document 2). Furthermore, a composition for a polymerization initiator containing a triarylboron compound and a cyclic ether compound has also been developed (Patent Document 3).

In addition, a thermosetting epoxy resin composition is known that contains an epoxy resin, a specific aromatic amine compound, a specific boron-phosphorus complex, and a specific phosphorus compound, and that can form a cured film having excellent voltage resistance, adhesiveness, and heat resistance in a short curing time (Patent Document 4). Further, Patent Document 5 discloses a curing catalyst containing a Lewis acid and a monoamine or a heterocyclic aromatic organic compound.

### Citation List

### Patent Document

Patent Document 1: WO 2012/036164
Patent Document 2: JP 2014-152194 A
Patent Document 3: JP 2019-218267 A
Patent Document 4: JP 2021-66890 A
Patent Document 5: JP 2008-544067 T

### Summary of Invention

### Technical Problem

As described above, a thermal-latent resin composition that initiates curing by heating has been known.

However, the present inventor has found that some cured products of the thermal-latent resin composition cause discoloration of a contact portion with a metal and a metal portion around the contact portion under humid heat conditions. Property deterioration and corrosion progress in the discolored metal portion, leading to insulation failure.

Accordingly, an object of the present invention is to provide a cationic polymerization initiator which is thermally latent and can control the initiation of polymerization of a compound having a cationically curable functional group by adjusting the temperature, a curable resin composition containing the cationic polymerization initiator, a bonded body of a cured product and a metal in which discoloration of the cured product and the metal under humid heat conditions is suppressed, use of a composition containing the cationic polymerization initiator and an amine compound as a thermal-latent cationic polymerization initiator, a method for curing a curable resin composition containing the cationic polymerization initiator and a compound having a cationically curable functional group, a method for producing a cured product using the cationic polymerization initiator, and a cured product produced by the production method.

### Solution to Problem

The present inventor has conducted intensive studies to solve the above problems. As a result, the present inventor has found that in a composition containing a complex of a Lewis acid-type cationic polymerization initiator and an amine compound, the proportion of a free amine compound that does not form a complex is also important for the corrosion resistance of a cured product or a metal, and thus has completed the present invention.

Hereinafter, the present invention will be described.
[1] A thermal-latent cationic polymerization initiator, including:
   a Lewis acid-type cationic polymerization initiator represented by Formula (I) below; and
   an amine compound, in which
   the Lewis acid-type cationic polymerization initiator and a moiety of the amine compound form a complex;
   a remaining moiety of the amine compound is present in a state free from the Lewis acid-type cationic polymerization initiator; and
   a mole ratio of an amino group included in the free amine compound to 1 mole of a boron atom included in the Lewis acid-type cationic polymerization initiator is from 0.15 to 1.70, 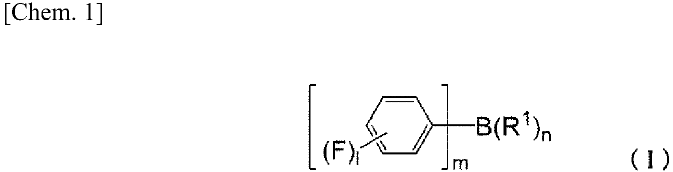
   where
   F represents a fluoro group;
   R¹ represents a hydrocarbon group optionally having a substituent;
   1 represents an integer of from 1 to 5;
   m represents an integer of from 1 to 3;
   n represents an integer of from 0 to 2;
   m + n = 3; and
   when n is 2, two R¹ groups are the same or different.
[2] The thermal-latent cationic polymerization initiator according to [1] above, further including a solvent.
[3] The thermal-latent cationic polymerization initiator according to [1] or [2] above, in which the amine compound is a hindered amine compound.
[4] The thermal-latent cationic polymerization initiator according to [1] or [2] above, in which the amine compound is an imidazole compound and a hindered amine compound.
[5] The thermal-latent cationic polymerization initiator according to any one of [1] to [4] above, in which the Lewis acid-type cationic polymerization initiator represented by Formula (I) above is tris(pentafluorophenyl)borane.
[6] A curable resin composition, including:
   a compound having a cationically curable functional group; and
   the thermal-latent cationic polymerization initiator described in any one of [1] to [5] above.
[7] The curable resin composition according to [6] above, in which the compound having a cationically curable functional group is at least one selected from the group consisting of an alicyclic epoxy compound, a hydrogenated epoxy compound, an aromatic epoxy compound, and an oxetane compound.
[8] A bonded body, including:
   a cured product of the curable resin composition described in [6] above; and
   a metal, in which
   the cured product and the metal are in contact with each other.
[9] A printed wiring board, including:
   an insulating layer including a cured product of the curable resin composition described in [6] above; and
   a conductor layer(s) on one or both surfaces of the insulating layer.
[10] Use of a composition including a Lewis acid-type cationic polymerization initiator represented by Formula (I) above and an amine compound as a thermal-latent cationic polymerization initiator, in which
   in the composition, the Lewis acid-type cationic polymerization initiator and a moiety of the amine compound form a complex;
   a remaining moiety of the amine compound is present in a state free from the Lewis acid-type cationic polymerization initiator; and
   a mole ratio of an amino group included in the free amine compound to 1 mole of a boron atom included in the Lewis acid-type cationic polymerization initiator is from 0.15 to 1.70.
[11] The use according to [10] above, in which the composition further includes a solvent.
[12] The use according to [10] or [11] above, in which the amine compound is a hindered amine compound.
[13] The use according to [10] or [11] above, in which the amine compound is an imidazole compound and a hindered amine compound.
[14] The use according to any one of [10] to [13] above, in which the Lewis acid-type cationic polymerization initiator represented by Formula (I) above is tris(pentafluorophenyl)borane.
[15] A method for curing a curable resin composition, the method including:
   heating the curable resin composition, in which
   the curable resin composition includes a compound having a cationically curable functional group and a thermal-latent cationic polymerization initiator;
   the thermal-latent cationic polymerization initiator includes a Lewis acid-type cationic polymerization initiator represented by Formula (I) above and an amine compound;
   the Lewis acid-type cationic polymerization initiator and a moiety of the amine compound form a complex;
   a remaining moiety of the amine compound is present in a state free from the Lewis acid-type cationic polymerization initiator; and
   a mole ratio of an amino group included in the free amine compound to 1 mole of a boron atom included in the Lewis acid-type cationic polymerization initiator is from 0.15 to 1.70.
[16] The method according to [15] above, in which the curable resin composition is heated at from 50°C to 200°C.
[17] The method according to [15] or [16] above, in which the thermal-latent cationic polymerization initiator further includes a solvent.
[18] The method according to any one of [15] to [17] above, in which the amine compound is a hindered amine compound.
[19] The method according to any one of [15] to [17] above, in which the amine compound is an imidazole compound and a hindered amine compound.
[20] The method according to any one of [15] to [19] above, in which the Lewis acid-type cationic polymerization initiator represented by Formula (I) above is tris(pentafluorophenyl)borane.
[21] The method according to any one of [15] to [20] above, in which the compound having a cationically curable functional group is at least one selected from the group consisting of an alicyclic epoxy compound, a hydrogenated epoxy compound, an aromatic epoxy compound, and an oxetane compound.
[22] A method for producing a cured product, including:
   mixing a compound having a cationically curable functional group and a thermal-latent cationic polymerization initiator to prepare a curable resin composition; and
   heating the curable resin composition, in which
   the thermal-latent cationic polymerization initiator includes a Lewis acid-type cationic polymerization initiator represented by Formula (I) above and an amine compound;
   the Lewis acid-type cationic polymerization initiator and a moiety of the amine compound form a complex;
   a remaining moiety of the amine compound is present in a state free from the Lewis acid-type cationic polymerization initiator; and
   a mole ratio of an amino group included in the free amine compound to 1 mole of a boron atom included in the Lewis acid-type cationic polymerization initiator is from 0.15 to 1.70.
[23] The method according to [22] above, further including forming the curable resin composition.
[24] The method according to [23] above, in which the curable resin composition is formed by a spin coating method, a solvent casting method, a dipping method, a spray coating method, or a dispenser method.
[25] A cured product of a curable resin composition including a Lewis acid-type cationic polymerization initiator represented by Formula (I) above, an amine compound, and a bisphenol epoxy compound represented by Formula (III) below: 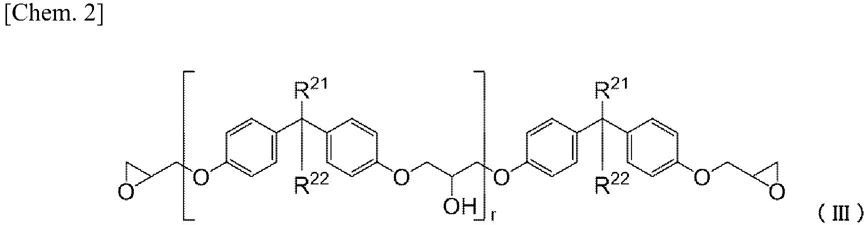 where
   R²¹ and R²² independently represent H, a C₁₋₆ alkyl group, a halogenated C₁₋₆ alkyl group, or a phenyl group, and R²¹ and R²² may combine to form a C₃₋₁₀ cycloalkyl group; and
   r represents an integer of from 0 to 100.

### Advantageous Effects of Invention

The curable resin composition according to the present invention exhibits excellent thermal latency, probably because the Lewis acid-type cationic polymerization initiator liberated by heating can catalyze the polymerization reaction of the compound having a cationically curable functional group. Therefore, the curable resin composition including the thermal-latent cationic polymerization initiator according to the present invention does not cure at room temperature, but starts to cure by heating, and therefore, curing can be controlled by adjusting the temperature. Furthermore, the cured product of the curable resin composition according to the present invention is less likely to discolor even under humid heat conditions, and the metal in contact therewith is also less likely to discolor, and therefore, the cured product is useful as, for example, a constituent component of an insulating layer of a metal-clad laminate in contact with a metal. In addition, in the cured product produced according to the present invention, defects such as coloration and cracking are suppressed. Therefore, the present invention is industrially excellent as a curable resin composition which can control curing and is excellent in quality after curing.

### Brief Description of Drawings

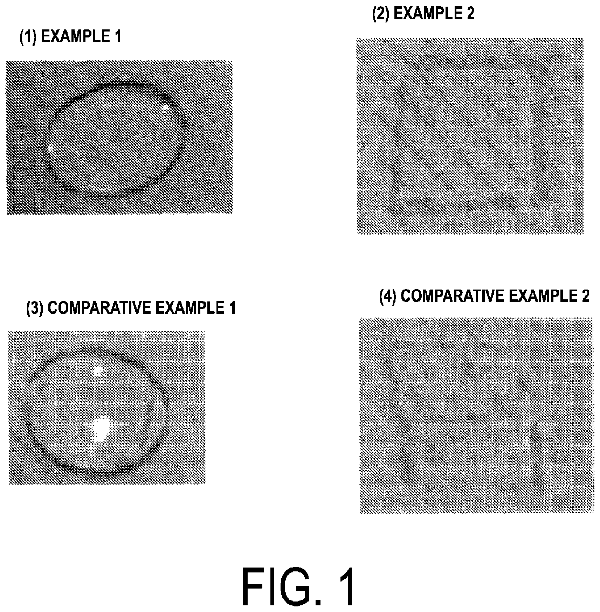

FIG. 1 shows photographs of the appearance of the cured products of Examples 1 and 2 and Comparative Examples 1 and 2.

### Description of Embodiments

The thermal-latent cationic polymerization initiator according to the present invention contains a Lewis acid-type cationic polymerization initiator represented by Formula (I) above (hereinafter, referred to as "Lewis acid-type cationic polymerization initiator (I)").

Thermal-latent polymerization initiators are mainly classified into protonic acid-type and Lewis acid-type; the protonic acid-type by-produces a strong acid by a reaction with a compound having a cationically curable functional group, whereas the Lewis acid-type does not produce a strong acid as a by-product, and a ligand coordinated to the Lewis acid-type cationic polymerization initiator functions as a stabilizer for the produced resin.

In Formula (I) above, examples of the hydrocarbon group include aliphatic hydrocarbon groups selected from a C₁₋₆ alkyl group, a C₂₋₆ alkenyl group, and a C₂₋₆ alkynyl group. Examples of the C₁₋₆ alkyl group include methyl, ethyl, n-propyl, isopropyl, n-butyl, isobutyl, s-butyl, t-butyl, n-pentyl, and n-hexyl. It is preferably a C₁₋₄ alkyl group, more preferably a C₁₋₂ alkyl group, and even more preferably methyl. Examples of C₂₋₆ alkenyl group include ethenyl (vinyl), 1-propenyl, 2-propenyl (allyl), isopropenyl, 2-butenyl, 3-butenyl, isobutenyl, pentenyl, and hexenyl. It is preferably a C₂₋₄ alkenyl group, and more preferably ethenyl (vinyl) or 2-propenyl (allyl). Examples of the C₂₋₆ alkynyl group include ethynyl, 1-propynyl, 2-propynyl, 2-butynyl, 3-butynyl, pentynyl, and hexynyl. It is preferably a C₂₋₄ alkynyl group, and more preferably ethynyl or propynyl.

Examples of the substituent which the hydrocarbon group may have include one or more substituents selected from a C₁₋₆ alkoxy group, a halogeno group, a cyano group (-CN), and a nitro group (-NO₂).

The C₁₋₆ alkoxy group refers to a linear or branched saturated aliphatic hydrocarbonoxy group having from 1 to 6 carbon atoms. Examples thereof include methoxy, ethoxy, n-propoxy, isopropoxy, n-butoxy, isobutoxy, t-butoxy, n-pentoxy, and n-hexoxy, preferably a C₁₋₄ alkoxy group, more preferably a C₁₋₂ alkoxy group, and even more preferably methoxy.

Examples of the halogeno group include fluoro, chloro, bromo, and iodo, and chloro or bromo is preferable, and chloro is more preferable.

The number of substituents in the hydrocarbon group is not particularly limited as long as the substituents can be substituted, and may be, for example, from 1 to 8. The number is preferably 6 or less or 4 or less, more preferably 3 or less or 2 or less, and even more preferably 1.

The number 1 of fluoro groups on the phenyl group is preferably 2 or more or 3 or more, more preferably 4 or more, and even more preferably 5.

The number m of phenyl groups is preferably 2 or more, and more preferably 3.

As the Lewis acid-type cationic polymerization initiator, for example, tris(pentafluorophenyl)borane is preferable.

The amine compound according to the present invention refers to an organic compound having an amino group, and also includes ammonia (NH₃). In other words, the amine compound according to the present invention is classified into ammonia, a primary amine compound, a secondary amine compound, and a tertiary amine compound. In the present invention, the nitrogen atom of the amine compound is coordinate-bonded to the boron atom of the Lewis acid-type cationic initiator (I) to suppress the catalytic ability of the Lewis acid-type cationic initiator (I), but the catalytic ability of the Lewis acid-type cationic initiator (I) is expressed by the dissociation of both by heating. In other words, the amine compound imparts thermal latency to the Lewis acid-type cationic initiator (I).

The primary amine compound is a compound (RNH₂) in which one of the hydrogen atoms of ammonia is substituted with a hydrocarbon residue. Examples of the primary amine compound include a compound represented by Formula (II¹) below. 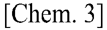 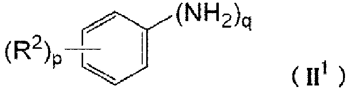 where
R² represents a C₁₋₆ alkyl group;
p represents an integer of from 0 to 5;
q represents an integer of from 1 to 6;
p + q ≤ 6; and
when p is an integer of 2 or more, two or more R² groups are the same or different.

The secondary amine compound is a compound (R²NH) in which two hydrogen atoms of ammonia are substituted with a hydrocarbon residue or the like, and the tertiary amine compound is a compound (NR₃) in which three hydrogen atoms of ammonia are substituted with a hydrocarbon residue or the like. Examples of the secondary amine compound and the tertiary amine compound include a compound having a piperidine structure represented by Formula (II²) below. 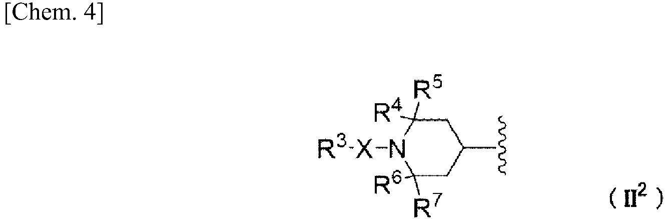 where
X represents an ether group (-O-) or a single bond; and
R³ to R⁷ independently represent H or a C₁₋₆ alkyl group.

Examples of the secondary amine compound and the tertiary amine compound include compounds represented by Formula (II³) or (II⁴) below. 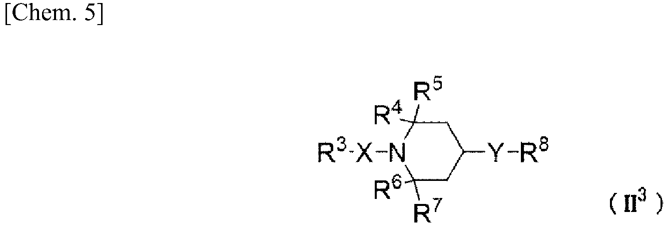 where
X and R³ to R⁷ are as defined above;
Y represents a linker group or a single bond; and
R⁸ represents H, a C₁₋₆ alkyl group, or the piperidine structure (II²) above.

The linker group exhibits an action of increasing the positional freedom of the piperidine structure (II²) or facilitating the synthesis of the compound, and is not particularly limited as long as it exhibits such an action; examples thereof include a C₁₋₁₀ alkanediyl group, an ether group (-O-), a thioether group (-S-), a carbonyl group (-C(=O)-), a thionyl group (-C(=S)-), an ester group (-O-C(=O)- or -C(=O)-O-), an amide group (-NH-C(=O)- or -C(=O)-NH-), a urea group (-NH-C(=O)-NH-), and a thiourea group (-NH-C(=S)-NH-); and a group in which from two to five of these groups are linked. Examples of the linked group include a C₁₋₁₀ alkanediyl group having a group selected from the group consisting of an ether group, a thioether group, a carbonyl group, a thionyl group, an ester group, an amide group, a urea group, and a thiourea group at one end or both ends. 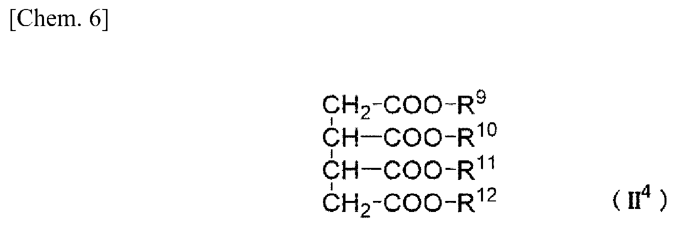 where one or more of R⁹ to R¹² represent the piperidine structure (II²), and the remaining ones represent C₁₋₂₀ alkyl groups.

As the amine compound, a hindered amine compound is preferable. The hindered amine compound refers to an amine compound in which the nucleophilicity of the lone electron pair of the nitrogen atom is weakened by steric hindrance or the like due to a substituent. Examples thereof include an amine compound having a piperidine structure (II²) in which all of R⁴ to R⁶ are C₁₋₆ alkyl groups.

Examples of the hindered amine compound include the following compounds.

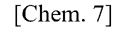

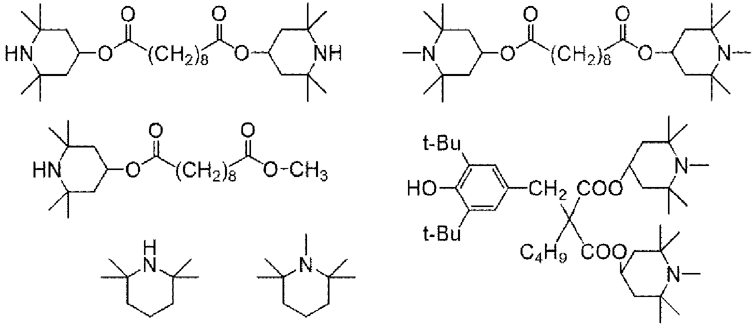

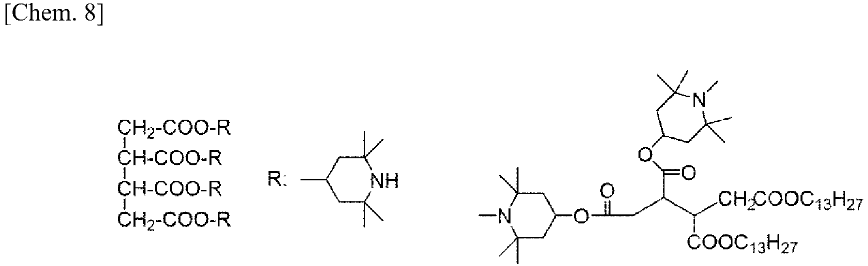

The amine compound may be an imidazole compound represented by the following formula. 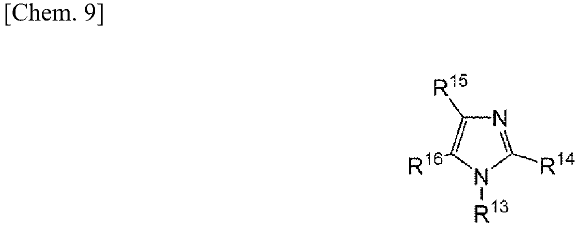 where R¹³ to R¹⁶ independently represent a hydrogen atom (-H) or a C₁₋₆ alkyl group.

In the imidazole compound, R¹⁶ is preferably a hydrogen atom.

In the amine compound, the C₁₋₆ alkyl group refers to a linear or branched monovalent saturated aliphatic hydrocarbon group having from 1 to 6 carbon atoms. Examples thereof include methyl, ethyl, n-propyl, isopropyl, n-butyl, isobutyl, s-butyl, t-butyl, n-pentyl, and n-hexyl. It is preferably a C₁₋₄ alkyl group, more preferably a C₁₋₂ alkyl group, and most preferably methyl.

Only one type of amine compound may be used, or a mixture of two or more types may be used. The mixture may be a mixture of amine compounds differing only in the number of carbon atoms of the alkyl group, or may be a mixture of different types of amine compounds. The number of amine compounds in the mixture is preferably 10 or less, more preferably 8 or less or 5 or less, and even more preferably 2. Examples of the mixture of amine compounds include a mixture of a hindered amine compound and an imidazole compound.

The proportions of the two amine compounds may be appropriately adjusted depending on the thermal-latent curability, the corrosion resistance, and the like. For example, the mole ratio of the hindered amino group to the non-hindered amino group can be from 1 to 10. The mole ratio is preferably 2 or more or 3 or more, and is preferably 8 or less or 5 or less.

The thermal-latent cationic polymerization initiator according to the present invention may contain a solvent. When a solvent is contained, mixing with the compound having a cationically curable functional group is facilitated, enhancing convenience. On the other hand, from the viewpoint of storage stability, a solvent may not be contained.

The solvent is not particularly limited as long as it can appropriately dissolve the Lewis acid-type cationic polymerization initiator (I), the amine compound, and the complex thereof, and examples thereof include alcohol solvents such as methanol, ethanol, and 2-propanol; ether solvents such as dimethyl ether, ethyl methyl ether, tetrahydrofuran, dioxane, and methoxycyclopentane; ketone solvents such as acetone and ethyl methyl ketone; ester solvents such as ethyl acetate and γ-butyrolactone; aliphatic hydrocarbon solvents such as n-pentane, n-hexane, cyclohexane, and methylcyclohexane; aromatic hydrocarbon solvents such as benzene and toluene; halogenated hydrocarbon solvents such as dichloroethane, chloroform, carbon tetrachloride, and chlorobenzene; and mixed solvents thereof, and among these, an ether solvent is preferable.

The solvent preferably has a boiling point of from 80°C to 160°C. When the boiling point is 80°C or higher, the curable resin composition can be sufficiently heated, and the curable resin composition can be sufficiently cured. In addition, when the boiling point is 160°C or lower, it is possible to prevent excessive heating of the curable resin composition. As the solvent, in particular, an ether-based solvent having a boiling point of from 80°C to 160°C is preferable, and an ether-based solvent having a boiling point of from 90°C to 120°C is more preferable. In addition, from the viewpoint of being capable of favorably forming a cured product such as a cured film having no cracks and uniform thickness, an ether-based solvent having a boiling point of from 90°C to 110°C is even more preferable.

When the thermal-latent cationic polymerization initiator according to the present invention contains a solvent, the concentration may be appropriately adjusted, and for example, the total concentration of the Lewis acid-type cationic polymerization initiator (I) and the amine compound can be adjusted to from 10 mass% to 80 mass%, and is preferably from 25 mass% to 50 mass%.

The neutral three coordinate boron compound is called borane and exhibits electron acceptability, and the amine compound has a lone electron pair on the nitrogen atom, and therefore, it is considered that the Lewis acid-type cationic polymerization initiator (I) and the amine compound form a complex. However, the present inventor has found that even when the Lewis acid-type cationic polymerization initiator (I) and the amine compound are mixed so that the mole ratio of boron atoms to nitrogen atoms in each of the compounds is 1:1, the two compounds do not necessarily form a complex in the exact proportion, although it is considered that the formation of the complex depends mainly on the structure of the amine compound.

The present inventor has also found that, by allowing an amine compound to act in an amount more than sufficient to form a complex with the Lewis acid-type cationic polymerization initiator (I) and allowing a free amine compound to be present in a specific proportion relative to the Lewis acid-type cationic polymerization initiator (I), not only thermal latency is imparted to the Lewis acid-type cationic polymerization initiator (I), but also a metal corrosion inhibitory effect is exhibited.

The free amine compound which is present in a state free from the Lewis acid-type cationic polymerization initiator (I) in addition to the formation of a complex with the Lewis acid-type cationic polymerization initiator (I) may be present alone in the thermal-latent cationic polymerization initiator, or may form, for example, a salt with another anion.

Specifically, the amine compound is allowed to act on the Lewis acid-type cationic polymerization initiator (I) in a solvent such that the amount of the amino group in the amine compound is more than 1 time the molar amount, thereby forming a complex with the Lewis acid-type cationic polymerization initiator (I) and the amine compound, and adjusting the mole ratio of the amino group contained in the free amine compound to 1 mole of the boron atom contained in the Lewis acid-type cationic polymerization initiator to from 0.15 to 1.70. When the mole ratio is 0.15 or more, the thermosetting property is more reliably exhibited. On the other hand, when the mole ratio is 1.70 or less, even when the cured product from the thermal-latent cationic polymerization initiator is in contact with a metal, corrosion of the cured product itself or the metal can be suppressed. The mole ratio is preferably 0.25 or more, and more preferably 0.30 or more; and is preferably 1.50 or less, and more preferably 1.00 or less.

In the present disclosure, the "remaining moiety of the amine compound" refers to an amine compound other than the amine compound that forms a complex of the Lewis acid-type cationic polymerization initiator and the amine compound among the amine compounds blended in the thermal-latent cationic polymerization initiator. In other words, the "remaining moiety of the amine compound" is independent of the thermal-latent cationic polymerization initiator and the complex in the thermal-latent cationic polymerization initiator, and is present in a free state as a free amine compound.

The amino group may represent an -NH₂ group in a narrow sense, but in the present disclosure, the amino group includes not only an -NH₂ group but also an -NH- group of a secondary amine compound, a > N- group of a tertiary amine compound, and ammonia itself in a case where ammonia is used as an amine compound in a broad sense.

Since the amine compound that forms a complex with the Lewis acid-type cationic polymerization initiator (I) has lost basicity, the concentration and amount of the amine compound present in a state free from the Lewis acid-type cationic polymerization initiator can be measured by acid titration of the thermal-latent cationic polymerization initiator. The concentration and amount of the free amine compound are measured in accordance with the second method of 3. Amine value measurement method (2) of Japanese Standards for Quasi-drug Ingredients 2006. Specifically, the thermal-latent cationic polymerization initiator and bromophenol blue are dissolved in ethanol, and the solution is titrated with 0.5 mol/L hydrochloric acid until the solution turns green. The amount of the free amine compound contained in the thermal-latent cationic polymerization initiator is determined from the amount and concentration of the acid added, and further, the mole ratio of the amino group contained in the free amine compound to 1 mole of the boron atom contained in the Lewis acid-type cationic polymerization initiator may be calculated.

The thermal-latent cationic polymerization initiator according to the present invention can be easily produced by simply mixing the Lewis acid-type cationic polymerization initiator (I) and the amine compound in a solvent. For example, the Lewis acid-type cationic polymerization initiator (I) and the amine compound may be mixed in a solvent at room temperature, more specifically, at a temperature from 10°C to 40°C. After mixing the Lewis acid-type cationic polymerization initiator (I) and the amine compound, the solvent may be distilled off. The post-reaction treatment may be carried out according to a common method.

The curable resin composition according to the present invention contains the thermal-latent cationic polymerization initiator and a compound having a cationically curable functional group. The compound having a cationically curable functional group is polymerized by the cationically curable functional group attacking a cation generated from the thermal-latent cationic polymerization initiator to generate a cation, and another cationically curable functional group attacking the generated cation.

Examples of the cationically curable functional group include a carbon-carbon double bond group and a cyclic ether group. Examples thereof include a vinyl group, an epoxy group, and an oxetanyl group.

Examples of the compound having a cationically curable functional group include aliphatic unsaturated hydrocarbons, aromatic compounds having a vinyl group, and cationically curable heteroatom-containing compounds.

Examples of the aliphatic unsaturated hydrocarbons include C₁₋₁₂ aliphatic unsaturated hydrocarbon compounds having one vinyl group, such as 1-butene, 2-butene, isobutene, 1-pentene, 3-methyl-1-butene, 1-hexene, 2-hexene, 3-methyl-1-pentene, 2,3-dimethyl-1-butene, 3,3-dimethyl-1-butene, vinylcyclopentane, 3,3-dimethyl-1-pentene, vinylcyclohexane, 1-octene, 2-octene, 2,4,4-trimethyl-1-pentene, vinylnorbornane, 1-decene, camphene, α-pinene, β-pinene, and vinyladamantane; and C₁₋₁₂ aliphatic unsaturated hydrocarbon compounds having two or more vinyl groups, such as butadiene, 1,4-pentadiene, cyclopentadiene, 1,5-hexadiene, 1,3-cyclohexadiene, 2,5-norbornadiene, dicyclopentadiene, 4-vinyl-cyclohexene, 5-vinyl-2-norbornene, and 5-ethylidene-2-norbornene.

Examples of the aromatic compound forming the aromatic compound having a vinyl group include C₆₋₁₈ aromatic compounds such as phenyl, naphthyl, anthryl, phenanthryl, and pyrenyl. Examples of the aromatic compound having a vinyl group include C₆₋₁₈ aromatic compounds having one vinyl group such as styrene, α-methylstyrene, 3-methylstyrene, 4-methylstyrene, 3-ethylstyrene, 4-ethylstyrene, 3-propylstyrene, 4-isopropylstyrene, 3-butylstyrene, 4-tert-butylstyrene, 4-hexylstyrene, 4-octylstyrene, 3-(2-ethylhexyl)styrene, 4-(2-ethylhexyl)styrene, 2,4-diphenyl-4-methyl-1-pentene, 1-vinylnaphthalene, 2-vinylnaphthalene, 2-isopropenylnaphthalene, 9-vinylanthracene, and 1-vinylanthracene; and C₆₋₁₈ aromatic compounds having two or more vinyl groups such as 1,3-divinylbenzene, 1,4-divinylbenzene, 1,3-diisopropenylbenzene, 1,4-diisopropenylbenzene, 1,4-divinylnaphthalene, 1,5-divinylnaphthalene, 1,4-diisopropenylnaphthalene, 9,10-divinylanthracene, allylstyrene, isopropenylstyrene, butenylstyrene, and octenylstyrene.

The cationically curable heteroatom-containing compound refers to a compound that contains a cationically curable functional group containing a heteroatom, such as an epoxy group or an oxetanyl group, and is polymerized by cations. Examples of the cationically curable heteroatom-containing compound having an epoxy group include epoxy resins having a cyclohexane skeleton, alicyclic epoxy resins, aliphatic epoxy resins, and aromatic epoxy compounds.

Examples of the epoxy resin having a cyclohexane skeleton include 1,2-epoxy-4-(2-oxiranyl)cyclohexane adduct of 2,2-bis(hydroxymethyl)-1-butanol.

Examples of the alicyclic epoxy resin include vinylcyclohexene monoxide 1,2-epoxy-4-vinylcyclohexane, 1,2:8,9-diepoxylimonene, 3,4-epoxycyclohexenylmethyl-3',4'-epoxycyclohexene carboxylate, 3,4-epoxycyclohexenylmethyl-3',4'-epoxycyclohexene carboxylate, and hydrogenated epoxy compounds.

Examples of the hydrogenated epoxy compound include a hydrogenated bisphenol A-type epoxy compound, a hydrogenated bisphenol F-type epoxy compound, a hydrogenated bisphenol E-type epoxy compound, a diglycidyl ether of a hydrogenated bisphenol A-type alkylene oxide adduct, a diglycidyl ether of a hydrogenated bisphenol F-type alkylene oxide adduct, a hydrogenated phenol novolac epoxy compound, and a hydrogenated cresol novolac epoxy compound.

Examples of the aliphatic epoxy resin include ethylene glycol diglycidyl ether, diethylene glycol diglycidyl ether, propylene glycol diglycidyl ether, tripropylene glycol diglycidyl ether, neopentyl glycol diglycidyl ether, 1,4-butanediol diglycidyl ether, 1,6-hexanediol diglycidyl ether, trimethylolpropane triglycidyl ether, trimethylolpropane diglycidyl ether, and polyethylene glycol diglycidyl ether.

Examples of the aromatic epoxy compound include an aromatic bisphenol A-type epoxy compound, an aromatic bisphenol F-type epoxy compound, an aromatic bisphenol E-type epoxy compound, a diglycidyl ether of an aromatic bisphenol A-type alkylene oxide adduct, a diglycidyl ether of an aromatic bisphenol F-type alkylene oxide adduct, a diglycidyl ether of an aromatic bisphenol E-type alkylene oxide adduct, an aromatic novolac-type epoxy compound, a urethane-modified aromatic epoxy compound, a nitrogen-containing aromatic epoxy compound, and a rubber-modified aromatic epoxy resin containing polybutadiene, nitrile butadiene rubber (NBR), or the like.

Examples of the oxetane compound, which is a cationically curable heteroatom-containing compound having an oxetanyl group, include 3-ethyl-3-(alkoxymethyl)oxetanes such as 3-ethyl-3-(hexyloxymethyl)oxetane, 3-ethyl-3-(heptyloxymethyl)oxetane, 3-ethyl-3-(2-ethylhexyloxymethyl)oxetane, 3-ethyl-3-(octyloxymethyl)oxetane, and 3-ethyl-3-(dodecyloxymethyl) oxetane.

The compound having a cationically curable functional group may be a bisphenol epoxy compound (III). The bisphenol epoxy compound (III) is, in some cases, a main component of a commercially available curable epoxy compound composition, but curing with a cationic polymerization initiator requires a high temperature, or the cured product may be cracked or colored. Examples of the curable epoxy compound composition product containing the bisphenol epoxy compound (III) include ACRYSET (tradename) BR series available from Nippon Shokubai Co., Ltd. and jER^{™} series available from Mitsubishi Chemical Corporation. 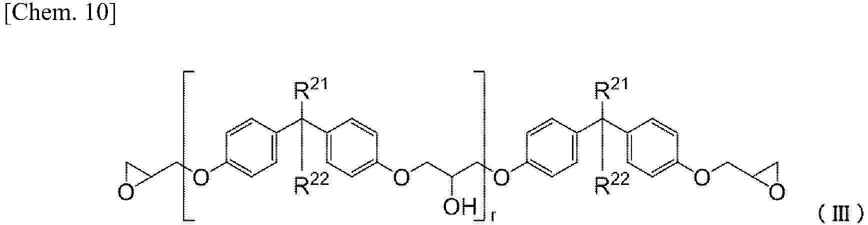 where
R²¹ and R²² independently represent H, a C₁₋₆ alkyl group, a halogenated C₁₋₆ alkyl group, or a phenyl group, and R²¹ and R²² may combine to form a C₃₋₁₀ cycloalkyl group; and
r represents an integer of from 0 to 100.

r may be 0. The upper limit of r is preferably 50 or less, more preferably 10 or less, and even more preferably 5 or less or 3 or less.

The proportions of the compound having a cationically curable functional group and the thermal-latent cationic polymerization initiator in the curable resin composition according to the present invention may be appropriately adjusted within a range in which the compound having a cationically curable functional group can be favorably cured, and for example, the mass ratio of the compound having a cationically curable functional group to 1 part by mass of the Lewis acid-type cationic polymerization initiator (I) contained in the latent cationic polymerization initiator may be adjusted to approximately from 50 to 200. The ratio is preferably 60 or more, and more preferably 80 or more; and is preferably 150 or less, and more preferably 120 or less.

In addition, the curable resin composition according to the present invention may contain additives such as an antistatic agent, a curing agent, a flame retardant, an antibacterial agent, an antioxidant, and a pigment. In order to improve the linear expansion coefficient and electrical characteristics, it is also preferable to blend particles such as silica particles.

In addition, the impact resistance of the cured product can be improved by blending rubber particles. Examples of the rubber particles include acrylic rubber particles, silicone rubber particles, and fluororubber particles. The particle size of the rubber particles is not particularly limited, but for example, those having a volume-based average particle size of from 0.05 µm to 2 µm can be used. The amount of the rubber particles to be blended in the curable resin composition is not particularly limited, and may be, for example, from 10 phr to 30 phr.

Hereinafter, the method for curing the curable resin composition and the method for producing a cured product according to the present invention will be described step by step, but the present invention is not limited to the following specific examples.

### 1. Preparation Step of Curable Resin Composition

In this step, a curable resin composition is prepared by mixing a compound having a cationically curable functional group and a thermal-latent cationic polymerization initiator. The thermal-latent cationic polymerization initiator according to the present invention contains a Lewis acid-type cationic polymerization initiator (I) and an amine compound.

### 2. Forming Step

In this step, the curable resin composition prepared in Step 1 is formed. The forming method is not particularly limited and may be appropriately selected, and examples thereof include a spin coating method, a solvent casting method, a dipping method, a spray coating method, and a dispenser method.

The spin coating method is a method involving coating a planar substrate with a liquid by utilizing a centrifugal force, and a liquid curable resin composition can be formed into a thin film by this method. The solvent casting method is a method involving casting a liquid curable resin composition into a mold for forming. The dipping method is a method of immersing a substrate to be a mold or a core in a liquid curable resin composition to form a coating film of the liquid curable resin composition on the surface of the substrate. The spray coating method is a method of spraying a liquid curable resin composition on the surface of a substrate to form a coating film of the liquid curable resin composition on the surface of the substrate. The dispenser method is a method of discharging a fixed amount of a liquid curable resin composition from a device called a dispenser onto a substrate to form a coating film of the liquid curable resin composition on the surface of the substrate.

### 3. Curing Step

In this step, the curable resin composition is cured by heating. The curable resin composition according to the present invention is not cured at room temperature due to the action of the thermal-latent cationic polymerization initiator according to the present invention, which serves as a polymerization catalyst. However, by heating, the thermal-latent cationic polymerization initiator according to the present invention exhibits its polymerization catalytic ability and is cured.

The initial curing temperature by the thermal-latent cationic polymerization initiator according to the present invention is preferably 50°C or higher. This is because when the initial curing temperature is 50°C or higher, curing hardly starts at room temperature. The temperature is more preferably 60°C or higher or 80°C or higher, and even more preferably 100°C or higher. On the other hand, if the temperature is too high, the cured product may decompose, and therefore the heating temperature is preferably 500°C or lower, more preferably 400°C or lower, further more preferably 300°C or lower, and even more preferably 200°C or lower.

It is considered that the thermal-latent cationic polymerization initiator according to the present invention dissociates from the amine compound by heating, thereby initiating a polymerization reaction. It is not clear whether the amine compound dissociated from the thermal-latent cationic polymerization initiator forms a complex again with the thermal-latent cationic polymerization initiator after the polymerization reaction or is present in a free form, but an amine compound having a low boiling point such as ammonia may evaporate from the cured product and the concentration thereof may become equal to or less than the detection limit.

When a cured product obtained by curing using a thermal-latent cationic polymerization initiator is in contact with a metal, the cured product itself or the metal may be discolored, particularly under high temperature or high humidity conditions. Property deterioration and corrosion progress in the discolored metal portion, leading to insulation failure. However, even when the cured product of the curable resin composition according to the present invention containing the thermal-latent cationic polymerization initiator is in contact with a metal, discoloration of the cured product of the curable resin composition and the metal is suppressed even under high temperature and high humidity conditions, probably due to the free amine compound present in an appropriate amount relative to the Lewis acid-type cationic polymerization initiator (I).

The bonded body according to the present invention includes a cured product of the curable resin composition and a metal, and the cured product and the metal are in contact with each other. As described above, the bonded body according to the present invention has excellent corrosion resistance of the cured product and the metal.

The metal contained in the bonded body is not particularly limited; examples thereof include copper, gold, silver, nickel, aluminum, and alloys such as stainless steel, and from the viewpoint of conductivity, handleability, cost, and the like, copper, silver, and nickel are preferable.

The shape of the metal is not particularly limited and may be appropriately selected, and the metal can be, for example, spherical, plate-shaped, tubular, bulk-shaped, linear, or sponge-shaped. The plate shape may be a foil shape of from about 5 µm to 200 µm. The thickness is preferably 10 µm or more, and is preferably 100 µm or less, more preferably 50 µm or less, and even more preferably 20 µm or less.

Also, the shape of the cured product is not particularly limited, and the cured product can be, for example, spherical, plate-shaped, tubular, bulk-shaped, linear, or sponge-shaped. The thickness of the plate-shaped object may also be appropriately selected, and can be, for example, from 10 µm to 500 µm. The thickness is preferably 15 µm or more, and more preferably 20 µm or more; and is preferably 200 µm or less, more preferably 150 µm or less, and even more preferably 50 µm.

A sheet formed from fibers such as carbon fibers may be impregnated with a curable resin composition containing a solvent to form a prepreg. The prepreg may be laminated with a metal foil, and the resulting laminate may be heated to cure the curable resin composition, thereby producing a metal-clad laminate.

In addition, the curable resin composition according to the present invention can be used as an adhesive between metals or between a metal and another member, a conductive paste containing a conductive metal, an anisotropic conductive film (ACF) material, a sealing agent for a circuit element in which a metal portion is exposed, and the like.

The combination of the Lewis acid-type cationic polymerization initiator (I) and the amine compound can favorably polymerize and cure the epoxy monomer at a relatively low temperature, as described above. For example, in the case of a bisphenol epoxy resin (III), a known thermal-latent cationic polymerization initiator cannot polymerize the resin unless the temperature is high, or even if the resin can be polymerized, defects such as coloration and cracks may occur. However, the combination of the Lewis acid-type cationic polymerization initiator (I) and the amine compound according to the present invention enables the bisphenol epoxy resin (III) to be polymerized and cured at a relatively low temperature while suppressing defects.

The cured product produced by the method of the present invention can also be used as a protective layer for a printed wiring board. Specifically, the curable resin composition of the present invention is placed on a flexible or insulating plastic film such as polyester or polyimide so as to cover a conductor pattern of a flexible printed wiring board having the conductor pattern formed by a printing technique, and the curable resin composition is cured by heating and pressing to obtain a flexible printed wiring board provided with a protective layer.

The cured product or semi-cured product of the present invention may be used as a resin film or prepreg. For example, the curable resin composition of the present invention is applied to a release film, and then cured or semi-cured by heating to form a film, thereby forming a resin film or a prepreg. The semi-curing is, for example, B-staging.

It is considered that the epoxy monomer is polymerized in a chain reaction by the following reaction, by the combination of the Lewis acid-type cationic polymerization initiator (I) according to the present invention and the amine compound. In the following formulas, R represents an unspecified hydrogen atom or organic group, and a plurality of R atoms or groups are the same or different.

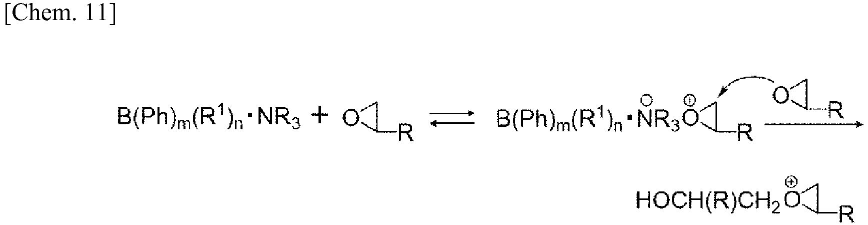

Since the bisphenol epoxy resin (III) has two epoxy groups, the cured product thereof may have a three dimensional or higher order structure. As a result, it is generally difficult to analyze the chemical structure of the polymer, but it is more difficult to analyze the chemical structure of the cured product of the bisphenol epoxy resin (III).

Since the epoxy monomer can be polymerized at a relatively low temperature according to the present invention, it is considered that at least a part of the Lewis acid-type cationic polymerization initiator (I) remains in the cured product. On the other hand, since some amine compounds have a low boiling point, such as ammonia, the content of the amine compound in the cured product may be below the detection limit.

The present application claims the benefit of priority based on Japanese Patent Application No. 2023-175040 filed on October 10, 2023, and Japanese Patent Application No. 2024-34825 filed on March 7, 2024. The entire disclosure of Japanese Patent Application No. 2023-175040 filed on October 10, 2023 and the entire disclosure of Japanese Patent Application No. 2024-34825 filed on March 7, 2024 are incorporated herein by reference.

### Examples

Hereinafter, the present invention will be described more specifically by way of Examples, but the present invention is not limited by the following Examples as a matter of course, and can be implemented with appropriate modifications within a range that can be adapted to the gist described above and below, and all of them are included in the technical scope of the present invention.

### Catalyst Production Example 1: Production of Cationic Polymerization Initiator 1-1

To tris(pentafluorophenyl)borane (0.906 g, 1.770 mmol, hereinafter abbreviated as "TPB"), 2 mol/L ammonia 2-propanol solution (available from FUJIFILM Wako Pure Chemical Corporation, containing 0.695 g, 1.770 mmol ammonia) was added, and the mixture was stirred for 1 hour until dissolved.

### Catalyst Production Example 2: Production of Cationic Polymerization Initiator 1-2

To TPB (0.906 g, 1.770 mmol), 2 mol/L ammonia 2-propanol solution (available from FUJIFILM Wako Pure Chemical Corporation, containing 0.834 g, 2.124 mmol ammonia) was added, and the mixture was stirred for 1 hour until dissolved.

### Catalyst Production Example 3: Production of Cationic Polymerization Initiator 1-3

To TPB (0.906 g, 1.770 mmol), 2 mol/L ammonia 2-propanol solution (available from FUJIFILM Wako Pure Chemical Corporation, containing 0.903 g, 2.301 mmol ammonia) was added, and the mixture was stirred for 1 hour until dissolved.

### Catalyst Production Example 4: Production of Cationic Polymerization Initiator 1-4

To TPB (0.906 g, 1.770 mmol), 2 mol/L ammonia 2-propanol solution (available from FUJIFILM Wako Pure Chemical Corporation, containing 1.042 g, 2.655 mmol ammonia) was added, and the mixture was stirred for 1 hour until dissolved.

### Catalyst Production Example 5: Production of Cationic Polymerization Initiator 1-5

To TPB (0.906 g, 1.770 mmol), 2 mol/L ammonia 2-propanol solution (available from FUJIFILM Wako Pure Chemical Corporation, containing 1.390 g, 3.540 mmol ammonia) was added, and the mixture was stirred for 1 hour until dissolved.

### Catalyst Production Example 6: Production of Cationic Polymerization Initiator 1-6

To TPB (0.906 g, 1.770 mmol), 2 mol/L ammonia 2-propanol solution (available from FUJIFILM Wako Pure Chemical Corporation, containing 2.084 g, 5.309 mmol ammonia) was added, and the mixture was stirred for 1 hour until dissolved.

### Catalyst Production Example 7: Production of Cationic Polymerization Initiator 2-1

To TPB (10.556 g, 20.617 mmol), 2,2,6,6-tetramethyl-4-piperidine ester of 1,2,3,4-butanetetracarboxylic acid ("ADK STAB LA57" available from Adeka Corporation, 2.039 g, 2.577 mmol) and methoxycyclopentane (14.000 g) were added, and the mixture was stirred for 1 hour until dissolved.

### Catalyst Production Example 8: Production of Cationic Polymerization Initiator 2-2

To TPB (10.556 g, 20.617 mmol), 2,2,6,6-tetramethyl-4-piperidine ester of 1,2,3,4-butanetetracarboxylic acid having the following chemical structure ("ADK STAB LA57" available from Adeka Corporation, 2.854 g, 3.608 mmol) and methoxycyclopentane (14.000 g) were added, and the mixture was stirred for 1 hour until dissolved.

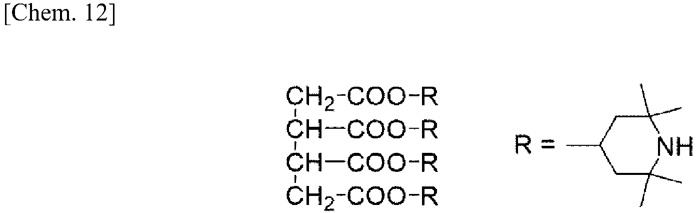

### Catalyst Production Example 9: Production of Cationic Polymerization Initiator 2-3

To TPB (10.556 g, 20.617 mmol), 2,2,6,6-tetramethyl-4-piperidine ester of 1,2,3,4-butanetetracarboxylic acid ("ADK STAB LA57" available from Adeka Corporation, 3.262 g, 4.123 mmol) and methoxycyclopentane (14.000 g) were added, and the mixture was stirred for 1 hour until dissolved.

### Catalyst Production Example 10: Production of Cationic Polymerization Initiator 2-4

To TPB (10.556 g, 20.617 mmol), 2,2,6,6-tetramethyl-4-piperidine ester of 1,2,3,4-butanetetracarboxylic acid ("ADK STAB LA57" available from Adeka Corporation, 4.077 g, 5.154 mmol) and methoxycyclopentane (14.000 g) were added, and the mixture was stirred for 1 hour until dissolved.

### Catalyst Production Example 11: Production of Cationic Polymerization Initiator 2-5

To TPB (10.556 g, 20.617 mmol), 2,2,6,6-tetramethyl-4-piperidine ester of 1,2,3,4-butanetetracarboxylic acid ("ADK STAB LA57" available from Adeka Corporation, 4.485 g, 5.669 mmol) and methoxycyclopentane (14.000 g) were added, and the mixture was stirred for 1 hour until dissolved.

### Catalyst Production Example 12: Production of Cationic Polymerization Initiator 2-6

To TPB (10.556 g, 20.617 mmol), 2,2,6,6-tetramethyl-4-piperidine ester of 1,2,3,4-butanetetracarboxylic acid ("ADK STAB LA57" available from Adeka Corporation, 5.300 g, 6.700 mmol) and methoxycyclopentane (14.000 g) were added, and the mixture was stirred for 1 hour until dissolved.

### Catalyst Production Example 13: Production of Cationic Polymerization Initiator 2-7

To TPB (10.556 g, 20.617 mmol), 2,2,6,6-tetramethyl-4-piperidine ester of 1,2,3,4-butanetetracarboxylic acid (available from Adeka Corporation, "ADK STAB LA57" available from Adeka Corporation, 8.154 g, 10.308 mmol) and methoxycyclopentane (14.000 g) were added, and the mixture was stirred for 1 hour until dissolved.

### Catalyst Production Example 14: Production of Cationic Polymerization Initiator 3-1

To TPB (10.556 g, 20.617 mmol), a hindered amine-based light stabilizer having the following chemical structure ("TINUVIN765" available from BASF, 6.309 g, 12.370 mmol) and methoxycyclopentane (14.000 g) were added, and the mixture was stirred for 1 hour until dissolved.

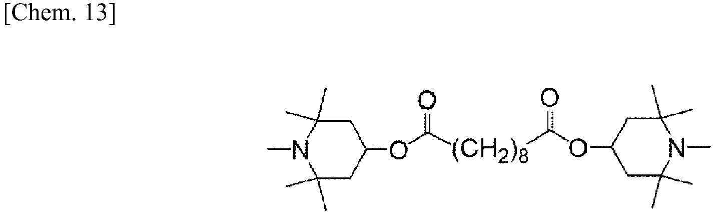

### Test Example 1: Measurement of Free Amine Value

The free amine value of the cationic polymerization initiator produced was measured.

Bromophenol blue was dissolved in ethanol to prepare a 0.1 mass% ethanol solution. This is hereinafter referred to as a BPB solution.

A cationic polymerization initiator (1 g) and a BPB solution (0.2 mL) were added to a vial containing ethanol (10 mL), and the vial was then capped and stirred for about 5 seconds. To the resulting solution, 0.5 mol/L hydrochloric acid (available from Kishida Chemical Co., Ltd.) was gradually added dropwise.

It was confirmed that the color of the solution changed from blue to green to yellow, and the point at which the color turned green was defined as the end point. The amine compound forming a complex with TPB does not react with hydrochloric acid, and the number of moles of hydrochloric acid required for the dropwise addition corresponds to the number of moles of amino groups contained in the free amine.

The number of moles of amino groups contained in the free amine per mole of boron in the cationic polymerization initiator subjected to the measurement is shown as a free amine value in Tables 1 and 2 together with the mole ratio (N/B) of the amine compound to boron in TPB used for the production of the cationic polymerization initiator. When the color of the solution before the dropwise addition of hydrochloric acid was green to yellow, the free amine value was defined as 0.

Although the commercially available cationic polymerization initiator ("San-Aid SI-80L" available from Sanshin Chemical Industry Co., Ltd.) used for comparison does not contain a free amine in its structure, the free amine value was determined to be 0 because the color of the solution was yellow from the beginning when measured in the same manner for the sake of completeness.

**[Table 1]**

| Cationic polymerization initiator | Mole ratio of N/B | Free amine value |
|---|---|---|
| 1-1 | 1.0 | 0.00 |
| 1-2 | 1.2 | 0.09 |
| 1-3 | 1.3 | 0.15 |
| 1-4 | 1.5 | 0.27 |
| 1-5 | 2.0 | 0.74 |
| 1-6 | 3.0 | 1.68 |
| Commercially available polymerization initiator | - | 0.00 |

**[Table 2]**

| Cationic polymerization initiator | Mole ratio of N/B | Free amine value |
|---|---|---|
| 2-1 | 0.5 | 0.00 |
| 2-2 | 0.7 | 0.00 |
| 2-3 | 0.8 | 0.30 |
| 2-4 | 1.0 | 0.66 |
| 2-5 | 1.1 | 0.72 |
| 2-6 | 1.3 | 0.98 |
| 2-7 | 2.0 | 1.80 |
| 3-1 | 1.2 | 0.35 |

### Resin Composition Production Example 1

A resin composition was obtained by uniformly mixing 1 part by mass of a cationic polymerization initiator with 100 parts by mass of an alicyclic epoxy compound ("Celloxide 2021P" available from Daicel Corporation) for 5 minutes. For comparison, a commercially available cationic polymerization initiator having the following chemical structure ("San-Aid SI-80L", available from Sanshin Chemical Industry Co., Ltd.) was used to obtain a resin composition in the same manner. At this point, some of the resin compositions were cured.

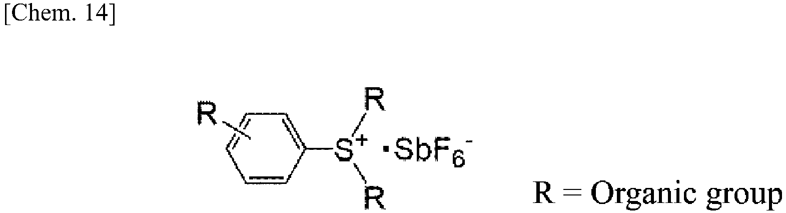

### Test Example 2: Thermosetting Test

The resin composition, which was uncured at the time of mixing, was dropped onto a copper plate of 0.3 × 50 × 50 mm, and spin-coated at 1000 rpm for 10 seconds. The copper plate coated with the resin composition was heated on a hot plate heated to 120°C for 1 hour to be thermoset.

### Test Example 3: Highly Accelerated Stress Test

Using a highly accelerated stress testing device ("PC-242HS-E" available from Hiranuma Manufacturing Corporation), each copper plate on which the resin composition was thermoset was kept under severe conditions of 100% RH and 120°C for 96 hours, and then the appearance was observed and evaluated according to the following criteria. The results are shown in Table 3.

**[Table 3]**

| Cationic polymerization initiator | Mole ratio of N/B | Spin coating results | Thermosetting | PCT (appearance) | |
|---|---|---|---|---|---|
| | | | | Copper plate | Cured product |
| 1-1 | 1.0 | Cured before coating | - | - | - |
| 1-2 | 1.2 | Cured before coating | - | - | - |
| 1-3 | 1.3 | Formation of smooth film | Cured | No discoloration | Slight yellowing |
| 1-4 | 1.5 | Formation of smooth film | Cured | No discoloration | Slight yellowing |
| 1-5 | 2.0 | Formation of smooth film | Cured | No discoloration | Slight yellowing |
| 1-6 | 3.0 | Formation of smooth film | Cured | No discoloration | Slight yellowing |
| 2-1 | 0.5 | Cured before coating | - | - | - |
| 2-2 | 0.7 | Cured before coating | - | - | - |
| 2-3 | 0.8 | Formation of smooth film | Cured | No discoloration | Colorless and transparent |
| 2-4 | 1.0 | Formation of smooth film | Cured | No discoloration | Colorless and transparent |
| 2-5 | 1.1 | Formation of smooth film | Cured | No discoloration | Colorless and transparent |
| 2-6 | 1.3 | Formation of smooth film | Cured | No discoloration | Colorless and transparent |
| 2-7 | 2.0 | Formation of smooth film | Uncured | No discoloration | Colorless and transparent |
| 3-1 | 1.2 | Formation of smooth film | Cured | No discoloration | Colorless and transparent |
| Commercially available product | 0 | Formation of smooth film | Cured | Black to green discoloration | Discoloration to brown |

As shown in the results in Table 3, the resin composition containing a commercially available cationic polymerization initiator ("San-Aid SI-80L" available from Sanshin Chemical Industry Co., Ltd.) which does not contain an amine compound as a constituent component exhibited thermosetting properties, but the cured product of the resin composition and the metal in the portions in contact with the cured product changed color from black to green under humid heat conditions.

In addition, the resin composition containing a cationic polymerization initiator having an excessively small free amine value relative to boron did not exhibit thermosetting properties, and curing was initiated only by mixing with the epoxy resin. On the other hand, the resin composition containing a cationic polymerization initiator having an excessively large free amine value relative to boron was not cured even by heating.

In contrast, the resin compositions containing the cationic polymerization initiators according to the present invention having a free amine value from 0.15 to 1.70 relative to boron exhibited thermosetting properties of not curing at room temperature but curing by heating, and the appearance of the cured product formed thereby did not change even when the cured product was in contact with metal under humid heat conditions.

Therefore, the cationic polymerization initiator compositions and the resin composition according to the present invention are very useful as a cured resin which can be cured in a controlled manner and is in contact with a metal, for example, a resin for forming an insulating layer of a circuit board.

### Catalyst Production Example 15: Production of Cationic Polymerization Initiator 4-1

To TPB (10.556 g, 20.617 mmol), a hindered amine-based light stabilizer having the following chemical structure ("TINUVIN770" available from BASF, 4.956 g, 10.309 mmol) and methoxycyclopentane (14.000 g) were added, and the mixture was stirred for 1 hour until dissolved.

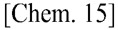

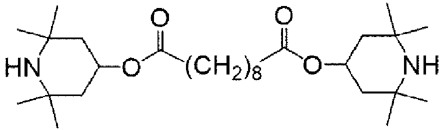

### Catalyst Production Example 16: Production of Cationic Polymerization Initiator 5-1

To TPB (10.556 g, 20.617 mmol), 2-ethyl-4-methylimidazole having the following chemical structure (available from Tokyo Chemical Industry Co., Ltd., 0.408 g, 3.711 mmol), 2,2,6,6-tetramethyl-4-piperidine ester of 1,2,3,4-butanetetracarboxylic acid (available from Adeka Corporation, "ADK STAB LA57" available from Adeka Corporation, 2.935 g, 3.711 mmol) and methoxycyclopentane (14.000 g) were added, and the mixture was stirred for 1 hour until dissolved.

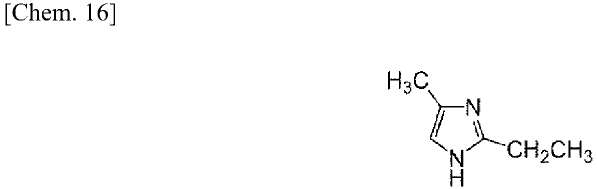

### Catalyst Production Example 17: Production of Cationic Polymerization Initiator 5-2

To TPB (10.556 g, 20.617 mmol), 2-ethyl-4-methylimidazole (available from Tokyo Chemical Industry Co., Ltd., 0.863 g, 7.832 mmol), 2,2,6,6-tetramethyl-4-piperidine ester of 1,2,3,4-butanetetracarboxylic acid (available from Adeka Corporation, "ADK STAB LA57" available from Adeka Corporation, 2.935 g, 3.711 mmol) and methoxycyclopentane (14.000 g) were added, and the mixture was stirred for 1 hour until dissolved.

### Catalyst Production Example 18: Production of Cationic Polymerization Initiator 5-3

To TPB (10.556 g, 20.617 mmol), 2-ethyl-4-methylimidazole (available from Tokyo Chemical Industry Co., Ltd., 1.544 g, 14.019 mmol), 2,2,6,6-tetramethyl-4-piperidine ester of 1,2,3,4-butanetetracarboxylic acid (available from Adeka Corporation, "ADK STAB LA57" available from Adeka Corporation, 2.935 g, 3.711 mmol) and methoxycyclopentane (14.000 g) were added, and the mixture was stirred for 1 hour until dissolved.

### Resin Composition Production Example 2

A resin composition was obtained in the same manner as in the resin composition production example 1, except that 100 parts by mass of an aromatic epoxy compound ("YL980" available from Adeka Corporation) was used instead of the alicyclic epoxy compound ("Celloxide 2021P" available from Daicel Corporation).

The thermosetting properties of each resin composition were tested in the same manner as in Test Example 2, and the highly accelerated stress of the cured product of each resin composition and the copper plate in contact with the cured product was tested in the same manner as in Test Example 3. The results are shown in Table 4.

**[Table 4]**

| Cationic polymerization initiator | Mole ratio of N/B | Free amine value | Spin coating results | Thermosetting | PCT (appearance) | |
|---|---|---|---|---|---|---|
| | | | | | Copper plate | Cured product |
| 4-1 | 1.0 | 0.22 | Formation of smooth film | Cured | No discoloration | Colorless and transparent |
| 5-1 | 0.9 | 0.35 | Formation of smooth film | Cured | No discoloration | Colorless and transparent |
| 5-2 | 1.1 | 0.50 | Formation of smooth film | Cured | No discoloration | Colorless and transparent |
| 5-3 | 1.4 | 0.71 | Formation of smooth film | Cured | No discoloration | Colorless and transparent |

As shown in the results in Table 4, the resin compositions containing not only a hindered amine as an amine compound but also an imidazole compound in addition to the hindered amine, and containing the cationic polymerization initiators according to the present invention having a free amine value from 0.15 to 1.70 relative to boron and an aromatic epoxy compound exhibited thermosetting properties of not curing at room temperature but curing by heating, and the appearance of the cured products formed thereby did not change even when in contact with a metal under humid heat conditions, and the appearance of the metal in contact with the cured product did not change.

Therefore, the cationic polymerization initiator compositions and the resin composition according to the present invention are very useful as a cured resin which can be cured in a controlled manner and is in contact with a metal, for example, a resin for forming an insulating layer of a circuit board.

### Resin Composition Production Example 3

Alicyclic epoxy compounds or aromatic epoxy compounds and cationic polymerization initiators shown in Table 5 were mixed at a mass ratio shown in Table 6 to obtain resin compositions.

**[Table 5]**

| | | |
|---|---|---|
| Alicyclic epoxy compound | Resin A | "Celloxide 2021P" available from Daicel Corporation |
| | Resin B | "YX8000" available from Mitsubishi Chemical Corporation |
| | Resin C | "YL980" available from Mitsubishi Chemical Corporation |
| Aromatic epoxy compound | Resin D | "Acryset BPA328" available from Nippon Shokubai Co., Ltd. |

**[Table 6]**

| | Resin A | Resin B | Resin C | Resin D | Catalyst production example | Commercially available initiator |
|---|---|---|---|---|---|---|
| Resin composition 1 | 100 | | | | 1 | |
| Resin composition 2 | | | 100 | | 1 | |
| Resin composition 3 | | | | 100 | 3 | |
| Resin composition 4 | 50 | 50 | | | 1 | |
| Resin composition 5 | 50 | | 50 | | 1 | |
| Resin composition 6 | | 50 | 50 | | 1 | |
| Resin composition 7 | 100 | | | | | 1 |
| Resin composition 8 | | | 100 | | | 1 |
| Resin composition 9 | | | | 100 | | 3 |

### Test Example 4: Thermosetting Test

The uncured resin compositions were formed on a substrate and thermoset under the conditions shown in Table 7, and the cured states and the appearance of the cured products were visually observed. The results are shown in Table 7. In addition, the photographs of the appearance of the cured products of Examples 1 and 2 and Comparative Examples 1 and 2 are shown in FIG. 1.

**[Table 7]**

| | | Forming method | Substrate | Curing conditions | Appearance of cured product |
|---|---|---|---|---|---|
| Example 1 | Resin composition 1 | Constant discharge (40 mg) | Glass plate | Hot plate at 120°C for 1 hour | Colorless transparent cured product |
| Example 2 | Resin composition 1 | Casting thickness of 4 mm (30 × 30 mm) | Glass plate | Hot plate at 120°C for 1 hour | Colorless transparent cured product |
| Example 3 | Resin composition 1 | Casting thickness of 2 mm (20 × 10 mm) | Aluminum foil | Oven at 140°C for 1 hour | Colorless transparent cured product |
| Example 4 | Resin composition 2 | Casting thickness of 2 mm (20 × 10 mm) | Aluminum foil | Oven at 140°C for 1 hour | Colorless transparent cured product |
| Example 5 | Resin composition 3 | Casting thickness of 2 mm (20 × 10 mm) | Aluminum foil | Oven at 160°C for 1 hour | White cured product |
| Comparative Example 1 | Resin composition 7 | Constant discharge (41 mg) | Glass plate | Hot plate at 120°C for 1 hour | Crack & light coloration |
| Comparative Example 2 | Resin composition 7 | Casting thickness of 4 mm (30 × 30 mm) | Glass plate | Hot plate at 120°C for 1 hour | Crack & coloration |
| Comparative Example 3 | Resin composition 7 | Casting thickness of 2 mm (20 × 10 mm) | Aluminum foil | Oven at 140°C for 1 hour | Colored cured product |
| Comparative Example 4 | Resin composition 8 | Casting thickness of 2 mm (20 × 10 mm) | Aluminum foil | Oven at 140°C for 1 hour | Uncured |
| Comparative Example 5 | Resin composition 9 | Casting thickness of 2 mm (20 × 11 mm) | Aluminum foil | Oven at 160°C for 1 hour | Uncured |

As shown in the results in Table 7 and FIG. 1, cracks and coloration were observed in the cured products of the resin compositions of Comparative Examples 1 to 3 containing an alicyclic epoxy resin and a commercially available cationic polymerization initiator.

In Comparative Examples 4 and 5, which contained an aromatic epoxy resin and a commercially available cationic polymerization initiator, curing failure occurred, and a cured product was not obtained.

In contrast, in Examples 1 to 5 according to the present invention, the curing reaction sufficiently proceeded by heating at 120 to 160°C for 1 hour in both the alicyclic epoxy resin and the aromatic resin, and a cured product without defects such as coloration and cracks could be obtained.

### Test Example 5: Differential Scanning Calorimetry

The heat generation characteristics of the curable resin compositions were measured using a differential scanning calorimeter ("DSC 3500" available from Netzsch Japan K. K.). The measurement conditions were a temperature rising rate of 10°C/min in a nitrogen atmosphere from 30°C to 250°C, and the measurement was performed. The results are shown in Table 8.

**[Table 8]**

| | Polymerization initiator | Initial curing temperature | Temperature at exothermic peak | Amount of heat generated |
|---|---|---|---|---|
| Resin composition 1 | Catalyst production example 1 | 69°C | 126°C | 561 J/g |
| Resin composition 2 | | 95°C | 126°C | 470 J/g |
| Resin composition 3 | | 104°C | 147°C | 355 J/g |
| Resin composition 4 | | 74°C | 96°C/124°C | 479 J/g |
| Resin composition 5 | | 72°C | 133°C | 419 J/g |
| Resin composition 6 | | 120°C | 149°C | 373 J/g |
| Resin composition 7 | Commercially available initiator | 84°C | 95°C/114°C | 524 J/g |
| Resin composition 8 | | 115°C | 130°C | 179 J/g |
| Resin composition 9 | | - | - | *0 J*/*g* |

As shown in the results in Table 8, even the commercially available initiator was able to polymerize the alicyclic epoxy compound (resin composition 7).

However, in the case of an aromatic epoxy compound, the curing reaction did not proceed at all (resin composition 9) or, even if it proceeded, the amount of heat generated was small and the curing was not sufficient (resin composition 8), when a commercially available initiator was used.

In contrast, in the resin compositions 1 to 6 according to the present invention, heat generation accompanying the curing reaction was observed in both the alicyclic epoxy compound and the aromatic epoxy compound, and the amount of heat generated was also large, so that it was found that the curing sufficiently proceeded.

### Test Example 6: Dynamic Viscoelasticity Measurement

The storage modulus, loss modulus, and tanδ of the cured products were measured using a dynamic viscoelasticity measurement apparatus ("DMA RSA-G2" available from TA Instruments Japan). The measurement conditions were three-point bending, a temperature rising rate of 5°C/min, and the measurement was performed from 30°C to 250°C with a normal load of 10 g and a sensitivity of 2 g. The sample size was set to 5 mm × 20 mm × thickness of 2 mm. The results are shown in Table 9.

**[Table 9]**

| | Storage modulus at 40°C | Loss modulus at 40°C | tanδ at 40°C | Tg |
|---|---|---|---|---|
| Example 3 | 7.1 × 10⁸ Pa | 1.2 × 10⁷ Pa | 0.0167 | 100°C |
| Example 4 | 6.2 × 10⁸ Pa | 6.5 × 10⁶ Pa | 0.0104 | 105°C |
| Example 5 | 4.1 × 10⁸ Pa | 5.5 × 10⁶ Pa | 0.0135 | 123°C |
| Comparative Example 3 | 5.8 × 10⁸ Pa | 5.3 × 10⁶ Pa | 0.0091 | 132°C |

The dynamic modulus includes a storage modulus (Pa) and a loss modulus (Pa), and the storage modulus is the component of energy generated by an external force and strain in the object that is stored inside the object, and the loss modulus is the component diffused to the outside. The tanδ is called a loss coefficient and is represented by loss modulus/storage modulus, and as the value is larger, the viscosity is higher and the energy generated by the strain is more likely to be diffused to the outside, and therefore, it can be said to be strong against impact. As shown in the results in Table 9, the cured products of Examples 3 to 5 according to the present invention exhibit a high Tg of 100°C or higher and a higher tanδ than the cured product of Comparative Example 3 using a commercially available initiator, and thus, it can be said to be cured products capable of diffusing external strain and having high impact resistance.

## Claims

1. A thermal-latent cationic polymerization initiator, comprising:
a Lewis acid-type cationic polymerization initiator represented by Formula (I) below; and
an amine compound, wherein
the Lewis acid-type cationic polymerization initiator and a moiety of the amine compound form a complex;
a remaining moiety of the amine compound is present in a state free from the Lewis acid-type cationic polymerization initiator; and
a mole ratio of an amino group included in the free amine compound to 1 mole of a boron atom included in the Lewis acid-type cationic polymerization initiator is from 0.15 to 1.70, 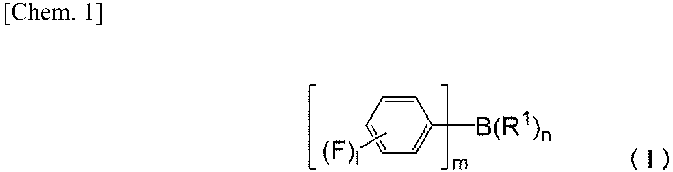
where
F represents a fluoro group;
R¹ represents a hydrocarbon group optionally having a substituent;
1 represents an integer of from 1 to 5;
m represents an integer of from 1 to 3;
n represents an integer of from 0 to 2;
m + n = 3; and
when n is 2, two R¹ groups are the same or different.

2. The thermal-latent cationic polymerization initiator according to claim 1, further comprising a solvent.

3. The thermal-latent cationic polymerization initiator according to claim 1, wherein the amine compound is a hindered amine compound.

4. The thermal-latent cationic polymerization initiator according to claim 1, wherein the amine compound is an imidazole compound and a hindered amine compound.

5. The thermal-latent cationic polymerization initiator according to claim 1, wherein the Lewis acid-type cationic polymerization initiator represented by Formula (I) above is tris(pentafluorophenyl)borane.

6. A curable resin composition, comprising:
a compound having a cationically curable functional group; and
the thermal-latent cationic polymerization initiator described in any one of claims 1 to 5.

7. The curable resin composition according to claim 6, wherein the compound having a cationically curable functional group is at least one selected from the group consisting of an alicyclic epoxy compound, a hydrogenated epoxy compound, an aromatic epoxy compound, and an oxetane compound.

8. A bonded body, comprising:
a cured product of the curable resin composition described in claim 6; and
a metal, wherein
the cured product and the metal are in contact with each other.

9. A printed wiring board, comprising:
an insulating layer including a cured product of the curable resin composition described in claim 6; and
a conductor layer(s) on one or both surfaces of the insulating layer.

10. Use of a composition including a Lewis acid-type cationic polymerization initiator represented by Formula (I) below and an amine compound as a thermal-latent cationic polymerization initiator, wherein
in the composition, the Lewis acid-type cationic polymerization initiator and a moiety of the amine compound form a complex;
a remaining moiety of the amine compound is present in a state free from the Lewis acid-type cationic polymerization initiator; and
a mole ratio of an amino group included in the free amine compound to 1 mole of a boron atom included in the Lewis acid-type cationic polymerization initiator is from 0.15 to 1.70, 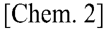 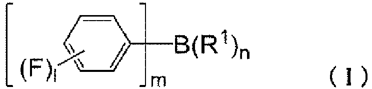
where
F represents a fluoro group;
R¹ represents a hydrocarbon group optionally having a substituent;
1 represents an integer of from 1 to 5;
m represents an integer of from 1 to 3;
n represents an integer of from 0 to 2;
m + n = 3; and
when n is 2, two R¹ groups are the same or different.

11. A method for curing a curable resin composition, comprising:
heating the curable resin composition, wherein
the curable resin composition includes a compound having a cationically curable functional group and a thermal-latent cationic polymerization initiator;
the thermal-latent cationic polymerization initiator includes a Lewis acid-type cationic polymerization initiator represented by Formula (I) below and an amine compound;
the Lewis acid-type cationic polymerization initiator and a moiety of the amine compound form a complex;
a remaining moiety of the amine compound is present in a state free from the Lewis acid-type cationic polymerization initiator; and
a mole ratio of an amino group included in the free amine compound to 1 mole of a boron atom included in the Lewis acid-type cationic polymerization initiator is from 0.15 to 1.70, 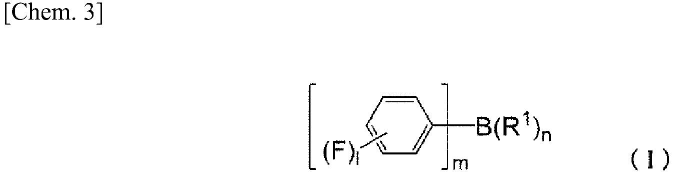
where
F represents a fluoro group;
R¹ represents a hydrocarbon group optionally having a substituent;
1 represents an integer of from 1 to 5;
m represents an integer of from 1 to 3;
n represents an integer of from 0 to 2;
m + n = 3; and
when n is 2, two R¹ groups are the same or different.

12. A method for producing a cured product, the method comprising:
mixing a compound having a cationically curable functional group and a thermal-latent cationic polymerization initiator to prepare a curable resin composition; and
heating the curable resin composition, wherein
the thermal-latent cationic polymerization initiator includes a Lewis acid-type cationic polymerization initiator represented by Formula (I) below and an amine compound;
the Lewis acid-type cationic polymerization initiator and a moiety of the amine compound form a complex;
a remaining moiety of the amine compound is present in a state free from the Lewis acid-type cationic polymerization initiator; and
a mole ratio of an amino group included in the free amine compound to 1 mole of a boron atom included in the Lewis acid-type cationic polymerization initiator is from 0.15 to 1.70, 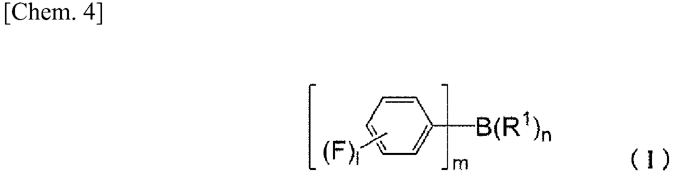
where
F represents a fluoro group;
R¹ represents a hydrocarbon group optionally having a substituent;
1 represents an integer of from 1 to 5;
m represents an integer of from 1 to 3;
n represents an integer of from 0 to 2;
m + n = 3; and
when n is 2, two R¹ groups are the same or different.

13. The method according to claim 12, further comprising forming the curable resin composition.

14. The method according to claim 13, wherein the curable resin composition is formed by a spin coating method, a solvent casting method, a dipping method, a spray coating method, or a dispenser method.
